# EUROPÄISCHE PATENTSCHRIFT

(11) **EP 1 186 012 B1**
(45) Veröffentlichungstag und Bekanntmachung des Hinweises auf die Patenterteilung: **23.04.2008**
(21) Anmeldenummer: 00927147.9
(22) Anmeldetag: 05.05.2000
(51) Int. Cl.: H01L 21/306, H01L 21/3063, H01L 31/18, H01L 31/0216, G02B 5/28

(54) **VERFAHREN ZUR HERSTELLUNG EINES ELEMENTS MIT POROSIDIERTEM MATERIAL**
METHOD FOR PRODUCING AN ELEMENT WITH MATERIAL THAT HAS BEEN MADE POROUS
PROCEDE POUR LA PRODUCTION D'UN ELEMENT AVEC DU MATERIAU RENDU POREUX

(30) Priorität: 07.05.1999 DE 19921190
(43) Veröffentlichungstag der Anmeldung: 13.03.2002
(73) Patentinhaber: Forschungszentrum Jülich GmbH, 52425 Jülich (DE)
(72) Erfinder: MARSO, Michel, D-52428 Jülich (DE); WOLTER, Mike, D-52072 Aachen (DE); ARENS-FISCHER, Rüdiger, D-72766 Reutlingen (DE)
(74) Vertreter: Paul, Dieter-Alfred
(86) Internationale Anmeldenummer: PCT/EP2000/004048
(87) Internationale Veröffentlichungsnummer: WO 2000/068983

(56) Entgegenhaltungen:
- WO-A-99/21033
- JP-A- 9 307 079
- US-A- 3 640 806
- US-A- 4 068 018
- US-A- 5 023 200
- PATENT ABSTRACTS OF JAPAN vol. 1998, no. 10, 31. August 1998 (1998-08-31) & JP 10 133047 A (KYOCERA CORP), 22. Mai 1998 (1998-05-22)
- PATENT ABSTRACTS OF JAPAN vol. 1999, no. 05, 31. Mai 1999 (1999-05-31) & JP 11 054477 A (TOKAI RIKA CO LTD), 26. Februar 1999 (1999-02-26)

## Beschreibung

Die Erfindung betrifft ein Verfahren zur Herstellung eines Elements gemäß dem Oberbegriff des Anspruchs 1.

Elemente aus Silicium mit einer oder mehreren Schichten aus porösem Silicium sind für eine Vielzahl von Anwendungen bekannt, beispielsweise als Interferenzfilter und -spiegel, als Farbdetektoren, als Trägersubstanzen für Chemo- oder Biosensoren oder für Photolumineszenz- oder Elektrolumineszenz-Anwendungen sowie als Wellenleiter etc. Die Herstellung solcher Siliciumelemente ist beispielsweise der EP-A-0 563 625 und - soweit es Siliciumelemente mit einer Vielzahl von übereinanderliegenden Schichten aus porösem Silicium betrifft - der US-A-5 696 629 zu entnehmen. Die Herstellung erfolgt grundsätzlich durch anodisches Ätzen eines Siliciumsubstrats aus einkristallinem, polykristallinem oder amorphem Silicium, wobei das Siliciumsubstrat gleichzeitig auch den Träger bilden kann. Unter anodischem Ätzen versteht man die Einwirkung eines Gleichstroms innerhalb eines aus einer Ätzlösung bestehenden Bades, wobei das Siliciumsubstrat die Anode bildet. Die Porosität und damit der optische Brechungsindex der so erzeugten Schicht aus porösem Silicium ist dann abhängig von der eingestellten Ätzstromdichte. Das anodische Ätzen zwecks Herstellung porösen Siliciums wird auch verkürzt als "Porosidieren" bzw. "Porosidierung" bezeichnet.

In der DE-C-195 18 371 ist ein spezielles verfahren zur Herstellung eines Siliciumelements beschrieben, bei dem auf einer Oberfläche des Siliciumstubstrats diskrete Abschnitte aus porösem Silicium - teilweise mehrschichtig - erzeugt werden. Um die Abschnitte zu begrenzen, werden die Restflächen, die nicht porosidiert werden sollen, durch Auftragen eines Photolacks abgeschirmt. Zusätzlich wird zwischen dem Photolack und dem Siliciumsubstrat eine nicht isolierende Schicht z. B. aus Titan vorgesehen, an die während der Porosidierung eine elektrische Spannung angelegt wird. Ziel dieser Maßnahme ist es, eine unterätzung der mit dem Photolack abgedeckten Bereiche zu vermeiden oder zumindest gezielt zu steuern.

Für eine Vielzahl von Anwendungen, z. B. als Mehrfarbendetektoren oder für die Erzeugung von farbigen Bildern, ist es erforderlich, auf einem Siliciumsubstrat nebeneinander oder beabstandet Abschnitte aus porösem Silicium unterschiedlichen Porositätsverlaufs zu erzeugen. Im Stand der Technik wird dies dadurch realisiert, daß zunächst großflächig mehrere übereinanderliegende Schichten aus porösem Silicium unterschiedlicher Porösität nach den oben beschriebenen Verfahren hergestellt und dann an den gewünschten Stellen die jeweils zuoberst liegende Schicht oder die zuoberst liegenden Schichten entfernt werden, wobei die Entfernung durch Wegätzen bewirkt wird (M. Frank et al. SPIE Proceedings Series, 1997, 3008, S. 265-272).

Dieses Verfahren ist nicht unproblematisch. Um eine gleichmäßige Filterwirkung über die gesamte Fläche des Siliciumsubstrats zu erhalten, müssen die zu entfernenden Schichten möglichst gleichförmig weggeätzt werden, da andernfalls die freigelegte Schicht eine ungleichmäßige Dicke mit der Folge hat, daß die Reflektion ungleichförmig ist. Außerdem muß eine Beschädigung der darunterliegenden Schicht verhindert werden. Beides erfordert eine sehr genaue Kontrolle des Ätzvorgangs, was sehr aufwendig ist, zumal für das Wegätzen teure Geräte benötigt werden.

Hinzu kommt, daß beim Wegätzen die oberste Schicht aus porösem Silicium abgedeckt werden muß, ohne daß die Abdeckung in die Poren des Siliciums eindringt. Um dies zu verhindern, muß zwischen dem aufzutragenden Photolack und dem porösem Silicium eine Schutzschicht vorgesehen werden. Diese muß anschließend durch Wegätzen entfernt werden, was ebenfalls ungleichmäßige Reflektionseigenschaften nach sich ziehen kann.

In Patent Abstracts of Japan, Band 1998, Nr. 10, 31. August 1998 (JP-A-10133047) ist ein Verfahren zur Herstellung eines Silicium-Elements beschrieben, bei dem auf ein Silicium-Substrat zunächst eine erste Abdeckung aufgetragen und der nicht abgedeckte Bereich durch eine anodische Oxidationsbehandlung in das Silicium-Substrat hinein porosidiert wird. Anschließend wird vollflächig, d.h. auch unter Abdeckung des schon porosidierten Bereichs, eine zweite Abdeckung aufgetragen. Beide Abdekkungen werden in Bereichen, die noch nicht porosidiert sind, entfernt. Durch einen zweiten Porosidierungsschritt wird eine Basisschicht erzeugt, die großflächiger ist als die erste Schicht. Schließlich wird die Abdeckung der ersten Schicht entfernt und eine thermische Oxidationsbehandlung zur Umwandlung des porosidierten Siliciums in einen Quarz vorgenommen. Dem folgt der Auftrag einer Abdeckschicht.

Der Erfindung liegt die Aufgabe zugrunde, Verfahren zur Herstellung von Elementen mit Abschnitten aus porösem Material unterschiedlichen Porositätsverlaufs bereitzustellen, mit denen gleichförmigere Schichten aus porösem Material und damit verbesserte physikalische Eigenschaften erzeugt werden können.

Diese Aufgabe wird bei einem gattungsgemäßen Verfahren erfindungsgemäß dadurch gelöst, daß eine Abdeckung nur vor dem ersten Porosidierungsschritt aufgetragen wird und nach diesem Porosidierungsschritt vollständig entfernt wird zwecks Porosidierung der Basisschicht ohne jegliche Abdeckunge Dieses Verfahren zeichnet sich gegenüber dem vorbekannten Verfahren dadurch aus, daß das teure und aufwendige Wegätzen wegfällt, d. h. dieses Verfahren ist einfacher und preisgünstiger als das nach dem Stand der Technik. Es treten zwar geringe Verzerrungen in den Randgebieten der Schichten auf. Für viele Anwendungszwecke kann dies jedoch in Kauf genommen werden.

Sofern mehr als zwei Schichten verwirklicht werden sollen, wird die Aufgabe dadurch gelöst, daß eine Abdeckung nur vor dem ersten Porosidierungsschritt in Form von mehreren Abdeckschichten unterschiedlicher Erstrekkung aufgebracht und nach jedem Porosidierungsschritt die jeweils außenliegende Abdeckschicht entfernt wird. Konkret kann dies dadurch geschehen, daß dann zwischen erster Schicht und Basisschicht wenigstens eine weitere Schicht aus porösem Material jeweils dadurch erzeugt wird, daß sie aus dem nicht porosidierten Substrat durch Porosidieren des Teilbereichs unterhalb der jeweils zuvor erzeugten Schicht, sowie wenigstens eines weiteren anschließenden Teilbereichs gebildet wird.

Um eine selektive Entfernung der jeweiligen Abdeckschicht sicherzustellen, können die Abdeckschichten aus unterschiedlichem Material, beispielsweise die eine aus Photolack und die andere aus Si₃N₄, und/oder in unterschiedlichen Schichtdicken hergestellt werden. Die Abdeckung bzw. die Abdeckschichten können zudem in Anwendung der aus der DE-C-195 18 371 bekannten Technik mit einer nicht isolierenden Schicht unterlegt sein, um während der Porosidierung eine elektrische Spannung zu erzeugen. Hierdurch können die oben erwähnten Randungleichförmigkeiten weitestgehend vermieden werden.

Das vorbeschriebene Verfahren eignet sich nicht nur für die Herstellung von Elementen aus Silicium, bei dem also Substrat und poröses Material aus Silicium bestehen. Grundsätzlich kann das verfahren für alle anderen Materialien, welche durch elektrochemisches Ätzen porosidiert werden können, angewendet werden, wie zum Beispiel Germanium (Ge), Silicium-Germanium (SiGe) Gallium-Phosphit (GaP), Gallium-Arsenid (GaAs) oder Aluminium-Gallium-Arsenid (AlGaAs).

Im übrigen versteht sich, daß mit den an sich bekannten Mitteln dafür gesorgt werden muß, daß die jeweils obenliegende porosidierte Schicht durch die jeweils darunterliegende porosidierte Schicht nicht gestört wird, was beispielsweise durch den Einbau lichtundurchlässiger Zwischenschichten geschehen kann. Ein anderer Weg besteht darin, die übereinanderliegenden Schichten hinsichtlich ihrer Porösität so auszulegen, daß der jeweils obenliegende Filter die gewünschte Charakteristik erst durch die Erzeugung und den Einfluß der darunterliegenden Schicht erhält.

In der Zeichnung ist die Erfindung anhand von schematisch dargestellten Ausführungsbeispielen näher veranschaulicht. Es zeigen jeweils im Vertikalschnitt
- die Figuren 1 bis 3: die Herstellung eines Interferenzfilters mit zwei Schichten aus porösem Silicium;
- die Figuren 4 bis 7: die Herstellung eines Interferenzfilters mit drei Schichten aus porösem Silicium mit einer Abdeckung aus zwei übereinander angeordneten Abdeckschichten.

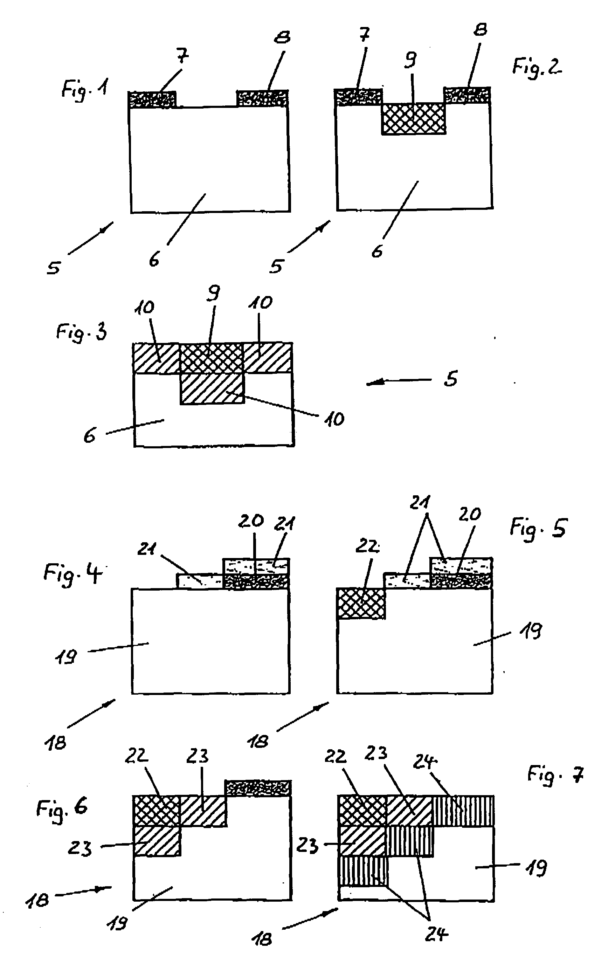

Figur 1 zeigt ein Siliciumelement 5, das ein Siliciumsubstrat 6 als Träger aufweist. Das Siliciumsubstrat 6 ist an der Oberseite in Außenabschnitten mit Abdeckungen 7, 8 beispielsweise in Form eines Photolacks versehen. Die Oberseite des Siliciumelements 5 wird dann einem Porosidierungsvorgang unterworfen mit der Folge, daß in dem Mittenabschnitt zwischen den beiden Abdeckungen 7, 8 aus dem Siliciumsubstrat 6 eine erste Filterschicht 9 bestimmter Porosität entsteht. In dieser Form ist das Siliciumelement 5 in Figur 2 zu sehen.

Anschließend werden die Abdeckungen 7, 8 entfernt, und es wird dann erneut eine Porosidierung der Oberseite des Siliciumelements 5 vorgenommen. Hierdurch entsteht eine zweite Filterschicht 10 mit zur ersten Filterschicht 9 abweichenden Porosität, wobei sich die zweite Filterschicht 10 auch unterhalb der ersten Filterschicht 9 erstreckt. Beide Filterschichten 9, 10 bilden eine bündige Oberfläche, wie Figur 3 erkennen läßt.

Die Figuren 4 bis 7 zeigen die Erzeugung drei Filterschichten. Figur 4 läßt ein Siliciumelement 18 aus einem Siliciumsubstrat 19 erkennen, das obenseitig mit einer ersten Abdeckschicht 20 versehen ist, die nur einen Außenabschnitt der Oberfläche des Siliciumsubstrats 19 abdeckt und beispielsweise aus Si₃N₄ besteht. Auf diese erste Abdeckschicht 20 ist eine zweite Abdeckschicht 21 beispielsweise aus einem Photolack aufgetragen, die sich auch über den Mittenabschnitt des Siliciumsubstrats 19 erstreckt und nur einen Außenabschnitt der Oberfläche des Siliciumsubstrats 19 freiläßt.

Das auf diese Weise mit zwei Abdeckschichten 20, 21 versehene Siliciumelement 18 wird an seiner Oberseite einem ersten Porosidierungsschritt unterworfen mit der Folge, daß in dem freigelassenen Außenabschnitt aus dem Siliciumsubstrat 19 eine erste Filterschicht 22 bestimmter Porosität entsteht. Das Siliciumelement 18 in dieser Form ist in Figur 5 zu sehen. Anschließend wird die zweite Abdeckschicht 21 selektiv, d. h. unter Beibehaltung der ersten Abdeckschicht 20 entfernt, so daß nur noch letztere übrigbleibt. Das Siliciumelement 18 wird dann einem weiteren Porosidierungsschritt unterworfen, wobei eine zweite Filterschicht 23 aus dem Siliciumsubstrat 19 in dem von der zweiten Abdeckschicht 21 freigegebenen Mittenabschnitt entsteht, welche sich auch unterhalb der ersten Filterschicht 22 erstreckt (Figur 6). Diese zweite Filterschicht 23 hat eine Porosität, die von der der ersten Filterschicht 22 abweicht.

Schließlich wird auch die erste Abdeckschicht 20 entfernt, so daß die dortige Oberfläche des Siliciumsubstrats 19 freiliegt. In einem dritten Porosidierungsschritt wird aus dem Siliciumsubstrat 19 eine dritte Filterschicht 24 erzeugt, die sich auch unterhalb der zweiten Filterschicht 23 über die gesamte Breite des Siliciumelements 18 erstreckt und eine wiederum abweichende Porosität hat. Das auf diese weise hergestellte Interferenzfilter ist Figur 7 zu entnehmen.

## Patentansprüche

1. Verfahren zur Herstellung eines Elements (5), bei dem auf einem Träger (6) durch Porosidierung Abschnitte aus porösem Material erzeugt werden, die unterschiedlichen Porositätsverlauf und/oder unterschiedliche Porosität haben, indem eine Abdeckung (7, 8) auf einem auf dem Träger befindlichen oder ihn bildenden Substrat (6) aufgebracht und aus diesem Substrat (6) durch Porosidieren wenigstens eines nicht durch die Abdeckung (7, 8) geschützten Teilbereichs eine erste Schicht (9) aus porösem Material erzeugt und aus dem nicht porosidierten Substrat (6) nach Entfernen der Abdeckung (7, 8) durch Porosidieren eine Basisschicht (10) erzeugt werden, die großflächiger ist als die erste Schicht (9), **dadurch gekennzeichnet, daß** eine Abdeckung (7, 8) nur vor dem ersten Porosidierungsschritt aufgetragen wird und nach diesem Porosidierungsschritt vollständig entfernt wird zwecks Porosidierung der Basisschicht (10) ohne jegliche Abdeckung.

2. Verfahren zur Herstellung eines Elements (18), bei dem auf einem Träger (19) durch Porosidierung Abschnitte aus porösem Material erzeugt werden, die unterschiedlichen Porositätsverlauf und/oder unterschiedliche Porosität haben, indem eine Abdeckung (20, 21) auf einem auf dem Träger befindlichen oder ihn bildenden Substrat (19) aufgebracht und aus diesem Substrat (19) durch Porosidieren wenigstens eines nicht durch die Abdeckung (20, 21) geschützten Teilbereichs eine erste Schicht (22) aus porösem Material erzeugt und aus dem nicht porosidierten Substrat (19) nach Entfernen der Abdeckung (20, 21) durch Porosidieren eine Basisschicht (24) erzeugt werden, die großflächiger ist als die erste Schicht (22), **dadurch gekennzeichnet, daß** eine Abdeckung nur vor dem ersten Porosidierungsschritt in Form von mehreren Abdeckschichten (20, 21) unterschiedlicher Erstrekkung aufgebracht und nach jedem Porosidierungsschritt die jeweils außen liegende Abdeckschicht (20, 21) entfernt wird.

3. verfahren nach Anspruch 2, **dadurch gekennzeichnet, daß** zwischen erster Schicht (22) und Basisschicht (17, 24) wenigstens eine weitere Schicht (23) aus porösem Material jeweils **dadurch** erzeugt wird, daß sie aus dem nicht porosidierten Substrat (19) durch Porosidieren des Teilbereichs unterhalb der jeweils zuvor erzeugten Schicht (22), sowie wenigstens eines weiteren anschließenden Teilbereichs gebildet wird.

4. Verfahren nach einem der Ansprüche 1 bis 3, **dadurch gekennzeichnet, daß** das Substrat (6, 19), aus dem das poröse Material durch Porosidierung erzeugt wird, Silicium, Germanium, Silicium-Germanium, Gallium-Phosphit, Gallium-Arsenid und/oder Aluminium-Gallium-Arsenid ist.

## Claims

1. Method for producing an element (5), in which sections of porous material are produced on a support (6) by way of rendering them porous, said sections have a varying porosity curve and / or varying porosity, in which a covering (7, 8) is applied to a substrate (6) located on the support or forming said support and a first layer (9) of porous material is produced from this substrate (6) by way of rendering porous at least one sub-area that is not protected by the covering (7, 8) and following removal of the covering (7, 8) a base layer (10) is produced by way of rendering porous from the substrate (6), which has not been rendered porous, with said base layer having a larger area than the first layer (9), **characterised in that** a covering (7, 8) is only applied prior to the first step of rendering porous and following this step of rendering porous it is completely removed for the purposes of rendering porous the base layer (10) without any covering.

2. Method for producing an element (18), in which sections of porous material are produced on a support (19) by way of rendering them porous, said sections have a varying porosity curve and / or varying porosity, in which a covering (20, 21) is applied to a substrate (19) located on the support or forming said support and a first layer (22) of porous material is produced by way of rendering porous at least one sub-area of this substrate (19) that is not protected by the covering (20, 21) and following removal of the covering (20, 21) a base layer (24) is produced by way of rendering porous from the substrate (19), which has not been rendered porous, with said base layer having a larger area than the first layer (22), **characterised in that** a covering in the form of several covering layers (20, 21) of varying extents is only applied prior to the first step of rendering porous and following each step of rendering porous each externally located covering layer (20, 21) is removed.

3. Method according to claim 2, **characterised in that** at least a further layer (23) of porous material is produced in each instance between the first layer (22) and the base layer (17, 24), **in that** it is formed from the substrate (19) that has not been rendered porous by way of rendering porous the sub-area underneath the layer (22) produced previously in each instance, as well as at least a further adjoining sub-area.

4. Method according to claims 1 to 3, **characterised in that** the substrate (6, 19), from which the porous material is made by way of rendering porous is silicon, germanium, silicon germanium, gallium phosphite, gallium arsenide and / or aluminium gallium arsenide.

## Revendications

1. Procédé destiné à la fabrication d'un élément (5) dans le cadre duquel des portions de matériau poreux sont créées sur un support (6) par l'action servant à rendre poreux, lesquelles portions ont des profils de porosité différents et/ou une porosité différente, tout en apportant un revêtement (7, 8) sur un substrat (6) se trouvant sur le support ou le constituant, et en créant à partir de ce substrat (6) une première couche (9) de matériau poreux, en rendant poreuse au moins une zone non protégée par le revêtement (7, 8), et à partir du substrat (6) non rendu poreux une couche de base (10) par l'action servant à rendre poreux après l'enlèvement du revêtement (7, 8), celle-ci étant de plus grande surface que la première couche (9), **caractérisé en ce qu'**un revêtement (7, 8) n'est appliqué qu'avant la première étape de création de porosité et **en ce qu'**il est totalement enlevé après cette étape de création de porosité en rendant poreuse la couche de base (10), sans aucun revêtement.

2. Procédé destiné à la fabrication d'un élément (18), dans le cadre duquel des portions de matériau poreux sont créées sur un support (19) par l'action servant à rendre poreux, lesquelles portions ont des profils de porosité différents et/ou une porosité différente, tout en apportant un revêtement (20, 21) sur un substrat (19) se trouvant sur le support ou le constituant, et en créant à partir de ce substrat (19) une première couche (22) de matériau poreux, en rendant poreuse au moins une zone non protégée par le revêtement (20, 21), et à partir du substrat (19) non rendu poreux une couche de base (24) par l'action servant à rendre poreux après l'enlèvement du revêtement (20, 21), celle-ci étant de plus grande surface que la première couche (22), **caractérisé en ce qu'**un revêtement n'est apporté qu'avant la première étape de création de porosité sous forme de plusieurs couches de revêtement (20, 21) d'étendues variées et **en ce que** chacune des couches de revêtement se trouvant à l'extérieur (20, 21) est enlevée après chaque étape de création de porosité.

3. Procédé selon la revendication 2, **caractérisé en ce qu'**au moins une couche supplémentaire (23) de matériau poreux est chaque fois créée entre la première couche (22) et la couche de base (17, 24), par le fait qu'elle est formée à partir du substrat (19) non rendu poreux, en rendant poreuses la zone en dessous de la couche (22) précédemment créée ainsi que d'au moins une portion supplémentaire contigüe.

4. Procédé selon l'une quelconque des revendications 1 à 3, **caractérisé en ce que** le substrat (6, 19), à partir duquel est créé le matériau poreux par l'action servant à rendre poreux, est du silicium, du germanium, du silicium-germanium, du phosphite de gallium, de l'arséniure de gallium et/ou de l'arséniure d'aluminium-gallium.
